# FASCICULE DE BREVET EUROPEEN

(11) **EP 1 058 369 B1**
(45) Date de publication et mention de la délivrance du brevet: **15.08.2007**
(21) Numéro de dépôt: 00110593.1
(22) Date de dépôt: 18.05.2000
(51) Int. Cl.: H02K 9/28, H02K 19/36, H02K 11/04, H01L 23/367

(54) **Porte-balais à composant de commande pour alternateur de véhicule automobile**
Bürstenhalter mit Reglereinheit für Kraftfahrzeugwechselstromgeneratoren
Brush holder with control unit for vehicle alternators

(30) Priorité: 31.05.1999 FR 9907138
(43) Date de publication de la demande: 06.12.2000
(73) Titulaire: VALEO EQUIPEMENTS ELECTRIQUES MOTEUR, 94017 Creteil (FR)
(72) Inventeur: Vandenbossche, Mathieu, 75020 Paris (FR)
(74) Mandataire: Gamonal, Didier

(56) Documents cités:
- EP-A- 0 350 593
- EP-A- 0 682 467
- EP-A- 0 731 550
- DE-A- 19 811 601
- US-A- 4 538 169
- US-A- 5 536 972
- US-A- 5 675 205
- PATENT ABSTRACTS OF JAPAN vol. 6, no. 60 (E-102), 17 avril 1982 (1982-04-17) & JP 57 003562 A (HITACHI LTD), 9 janvier 1982 (1982-01-09)
- PATENT ABSTRACTS OF JAPAN vol. 7, no. 4 (E-151), 8 janvier 1983 (1983-01-08) & JP 57 164541 A (HITACHI SEISAKUSHO KK), 9 octobre 1982 (1982-10-09)

## Description

L'invention concerne les porte-balais pour machine électrique de véhicule, notamment pour alternateur, alterno-démarreur et démarreur.

On connaît par le document US-A-5,675,205 , un tel porte-balais muni d'un support isolant, d'une embase métallique et d'un composant de commande à semi-conducteur. Ce composant est monté sur l'embase à la faveur d'une ouverture du support. Cette ouverture est donc fermée par l'embase, ainsi que par un couvercle pour formation d'un boîtier de logement du composant.

L'embase appartient à un moyen de dissipation de la chaleur. Plus précisément dans ce porte-balais, la chaleur générée par le composant de commande est transférée à l'embase, puis de l'embase, elle est transférée vers l'extérieur par conduction ou par convection. Cette dissipation peut s'avérer insuffisante et entraîner des surchauffes réduisant la durée de vie du porte-balais et du composant.

Pour mieux évacuer la chaleur, on peut songer à modifier le couvercle du boîtier pour que celui-ci constitue un dissipateur de chaleur appartenant au moyen de dissipation de la chaleur comme visible par exemple dans les figures 2 et 5 du document EP-A-0 731 550 (US-A-5,686,780). Par ailleurs, dans le document EP0484 287, il est décrit un porte-balais de machine électrique de véhicule muni d'une embase métallique et d'un composant à semi-conducteur. Ce composant est monté sur une face de l'embase. Un dissipateur est monté sur l'embase sur la face sur laquelle se trouve le composant; plus précisément au dessus. Ce dissipateur forme un boîtier pour le circuit. Par ailleurs, le porte-balais se fixe sur la machine du côté opposé à la face sur laquelle se trouve le composant à semi-conducteur.

La Demanderesse s'est demandée s'il n'est pas possible d'accroître encore l'efficacité du moyen de dissipation de la chaleur et ce de manière simple et économique.

C'est donc un but de l'invention de fournir un porte-balais permettant encore une meilleure évacuation de la chaleur de manière fiable, simple et économique.

En vue de la réalisation de ce but, on prévoit selon l'invention un porte-balais de machine électrique de véhicule, le porte-balais étant adapté à être monté sur un carter de la machine électrique, comportant un support, une embase métallique fixée au support, un circuit électrique comprenant au moins un composant de commande à semi-conducteur, dans lequel l'embase, d'une part, reçoit à fixation sur une de ces faces le composant de commande à la faveur d'une ouverture du support et, d'autre part, appartient à un moyen de dissipation de chaleur agencé pour recevoir de la chaleur du composant de commande, caractérisé en ce que le composant de commande est destiné à être disposé du côté de la machine électrique et en ce que ladite embase reçoit sur l'autre de ses faces un dissipateur de chaleur métallique en sorte que le moyen de dissipation de chaleur est composé de deux parties distinctes et adjacentes, le moyen de dissipation de chaleur étant en contact avec le milieu ambiant extérieur de la machine.

Ainsi une partie du moyen de dissipation, formant dissipateur, assure uniquement la fonction d'évacuation de la chaleur. Il peut donc être librement conçu pour évacuer rapidement une grande quantité de chaleur et éviter tout risque de surchauffe, contrairement à l'autre partie, à savoir l'embase qui doit être réalisée en fer, fer-nickel ou cuivre pour respecter les coefficients de dilatation des composants électroniques de commande.

Les coefficients de dilatation du dissipateur et de l'embase sont donc différents, l'embase ayant un coefficient de dilatation adaptée à celui du composant de commande, tandis que le dissipateur a avantageusement un coefficient de dilatation plus important que celui de l'embase pour mieux évacuer la chaleur.

Le dissipateur est avantageusement métallique par exemple à base d'aluminium ou en variante de magnésium ou autre matière moulable évacuant bien la chaleur. En variante le dissipateur est en métal fritté.

Ce dissipateur est une pièce d'adaptation, qui peut ainsi avoir la forme voulue selon les applications.

Grâce à l'invention on peut standardiser l'embase et adapter le dissipateur en fonction des applications.

La solution selon l'invention est efficace du fait que les deux parties du moyen de dissipation de chaleur métallique, à savoir l'embase et le dissipateur, sont adjacentes, ce qui permet de bien évacuer la chaleur.

La solution est également simple du fait que le composant de commande et le dissipateur de chaleur sont disposés de part et d'autre de l'embase en sorte qu'il n'y a pas à prévoir de boîtier.

L'empilement composant de commande - embase - dissipateur est obtenu donc de manière simple et économique.

L'embase, en contact avec le milieu ambiant, constitue l'un des dissipateurs du porte-balais grâce à l'ouverture du support permettant de réduire l'encombrement localement au niveau du composant de commande.

Avantageusement, de manière simple et économique, pour une bonne fixation, et pour réduire l'encombrement, le support est surmoulé sur l'embase et/ou sur le dissipateur.

Avantageusement, pour favoriser la standardisation, le dissipateur est rapporté sur le support par exemple de manière amovible par clipsage, vissage etc. Ceci permet de modifier le moins possible le porte-balais.

Avantageusement, le dissipateur est fixé par vis sur le support ce qui est favorable pour diminuer la hauteur du dissipateur tout en ne diminuant pas l'efficacité de celui-ci par augmentation de sa largeur.

Avantageusement, le porte-balais comprend une couche thermiquement conductrice interposée entre l'embase et le dissipateur.

Avantageusement, l'embase et le dissipateur sont en contact direct.

Avantageusement, l'un au moins parmi l'embase et le dissipateur présente des reliefs saillants aptes à pénétrer dans le matériau de l'autre parmi l'embase et le dissipateur lorsqu'ils sont placés en position de fonctionnement du porte-balais.

Ainsi, on assure une bonne transmission de chaleur entre l'embase et le dissipateur même si leur contact mutuel surface contre surface est médiocre, voire absent.

Avantageusement, le dissipateur est en matériau plus léger que l'embase par exemple en aluminium ou tout autre matière évacuant bien la chaleur.

On prévoit également selon l'invention une machine électrique de véhicule comprenant un porte-balais selon l'invention.

Dans tous les cas l'embase et le dissipateur sont adjacents en étant en contact direct ou indirect, via une couche thermiquement conductrice, en sorte qu'une bonne transmission de chaleur est réalisée. De même le composant de commande est en contact direct ou indirect, via une couche conductrice de chaleur, avec l'embase en sorte qu'une bonne transmission de chaleur est réalisée.

Bien entendu le composant de commande peut être noyé dans une résine assurant l'étanchéité de celui-ci comme décrit dans les documents US-A-5,675,205 et EP-A-0 731 550 précités.

On appréciera que grâce à l'invention on est beaucoup plus libre que dans les deux documents précités puisque le composant de commande et le dissipateur s'étendent de part et d'autre de l'embase. Une des faces de l'embase est dédiée à la fixation du composant de commande, tandis que l'autre face est dédiée au dissipateur.

Grâce à l'invention on a donc beaucoup plus de possibilités notamment en ce qui concerne les formes et le nombre de réalisations possibles. Par exemple la taille du dissipateur n'est pas imposée par des conditions de fermeture d'un boîtier. Le dissipateur peut donc être monté à jeu dans l'ouverture du support. La section du dissipateur peut être quelconque par exemple ronde, rectangulaire ou polygonale.

Lorsque le dissipateur est fixé par vis comme précité, on pourra prévoir que la ou au moins l'une des vis de montage du dissipateur sur le support assure en outre la fixation du porte-balais sur un carter de la machine ce qui permet de ne pas modifier le porte-balais.

Ainsi, la ou les mêmes vis assurent la fixation du dissipateur au porte-balais et la fixation du porte-balais à la machine.

Avantageusement, un élément thermiquement isolant est interposé entre la ou chaque vis et le dissipateur.

On évite ainsi la transmission de chaleur du carter jusqu'au dissipateur via la ou les vis, qui permettent un démontage ultérieur du dissipateur.

On appréciera, lorsque le dissipateur est rapporté de manière amovible sur l'embase ou sur le support, que l'on peut standardiser au maximum le porte-balais, qui ainsi peut être équipé à volonté du dissipateur.

La machine pourra être un alternateur, un alterno-démarreur ou un démarreur.

D'autres caractéristiques et avantages de l'invention apparaîtront encore dans la description suivante de quatre modes préférés de réalisation donnés à titre d'exemples non limitatifs. Aux dessins annexés:
- la figure 1 est une vue de dessus d'un porte-balais selon un premier mode préféré de réalisation de l'invention ;
- la figure 2 est une vue de dessous du porte-balais de la figure 1 ;
- la figure 3 est une vue à plus grande échelle d'un détail de la figure 2 ;
- la figure 4 est une vue en section du porte-balais de la figure 3 suivant le plan IV-IV ;
- la figure 5 est une vue en coupe d'un porte-balais selon un deuxième mode de réalisation, fixé à la machine ; et
- les figures 6 et 7 sont des vues en coupe de détail illustrant les troisième et quatrième modes de réalisation de l'invention.

Dans les figures le porte-balais selon l'invention est destiné à équiper un alternateur ou un alterno-démarreur de véhicule automobile à moteur à combustion interne.

Ainsi qu'on le sait un alternateur comporte un carter doté d'un palier avant et d'un palier arrière assemblés l'un avec l'autre, par exemple par vissage.

Le carter porte intérieurement un stator bobiné et polyphasé entourant un rotor comportant au moins un bobinage d'excitation.

Le rotor est solidaire d'un arbre portant à son extrémité avant une poulie et à l'arrière un collecteur comportant deux bagues collectrices reliées aux extrémités du bobinage d'excitation. Le palier arrière sert de support à un porte-balais doté de balais destinés chacun à frotter sur une bague collectrice et à être reliés à un composant de commande formant dans ce cas régulateur de tension. Ce régulateur pilote l'alimentation de la bobine d'excitation du rotor et est relié au pont de redressement, usuellement à diodes, branché sur les phases des enroulements du stator.

Pour plus de précisions on se reportera au document EP-A-0 731 550 précité, l'alternateur étant classiquement du type triphasé.

L'alternateur fonctionne en générateur et transforme de l'énergie mécanique en énergie électrique.

L'alternateur est une machine électrique tournante qui peut être réversible et donc transformer également de l'énergie électrique en énergie mécanique notamment pour démarrer le moteur du véhicule automobile, la machine étant alors appelée alterno-démarreur.

Pour plus de précisions on se reportera au document EP-A-0 792 769 décrivant un mode de réalisation avec un pont de redressement doté d'interrupteurs commandés, tels que des transistors du type Mosfet, pour création d'un alterno-démarreur.

Dans un alternateur le pont de redressement est classiquement porté par le palier arrière du carter de la machine, tandis que dans un alterno-démarreur le pont de redressement peut être monté à l'extérieur de la machine.

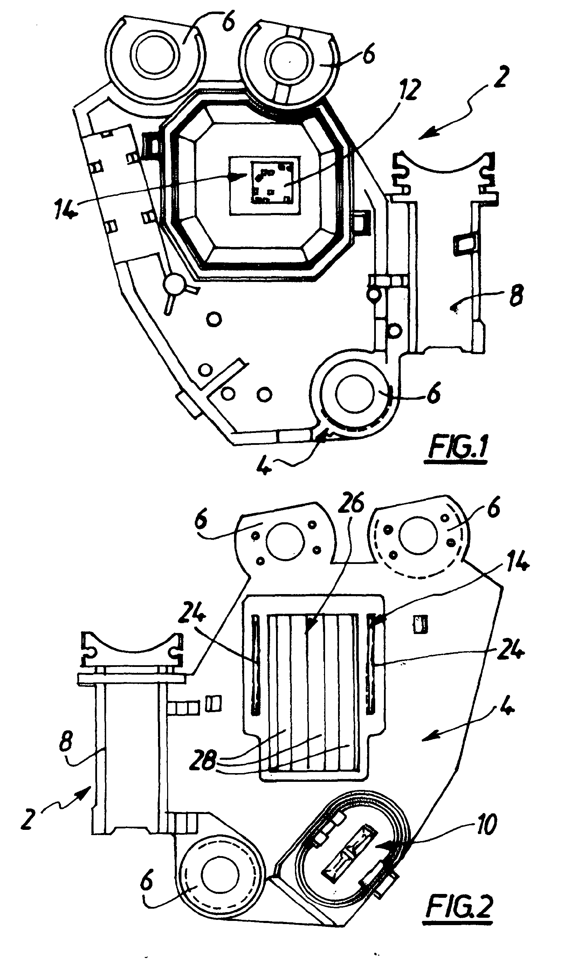

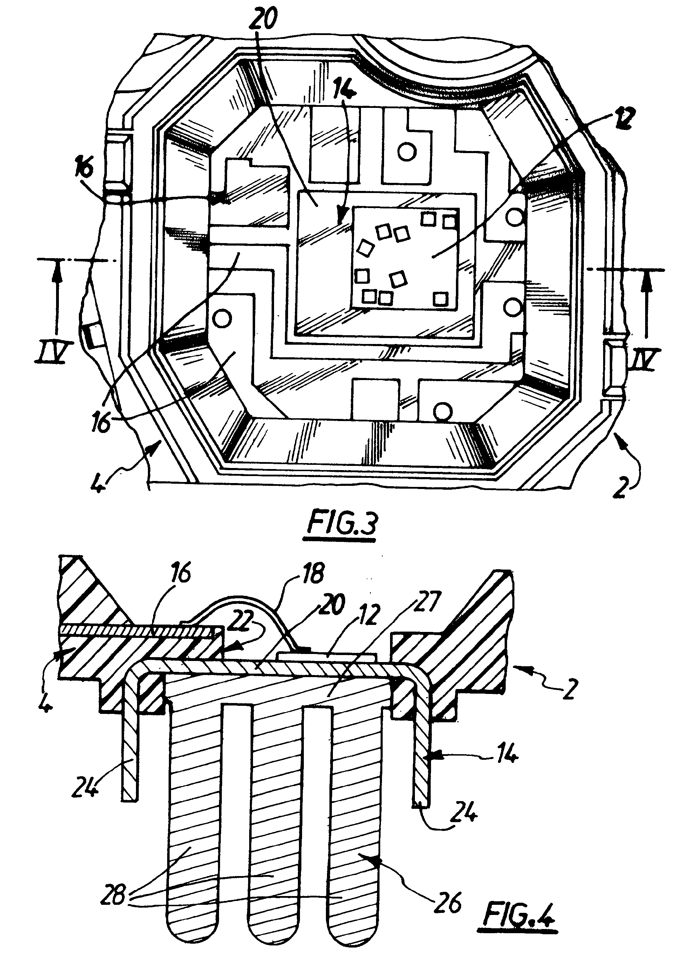

On a illustré aux figures 1 à 4 un premier mode de réalisation du porte-balais selon l'invention, destiné en l'espèce à un alterno-démarreur de véhicule automobile. Le porte-balais 2 comporte un support 4 essentiellement plan en matière plastique électriquement isolante, présentant des orifices 6, ici au nombre de trois, pour sa fixation au carter de la machine, sur le palier arrière de celui-ci. Le porte-balais comporte une cage à balais 8 renfermant des balais destinés à venir en contact avec les bagues collectrices du collecteur de la machine. Le porte-balais comporte un connecteur 10 destiné à recevoir un module de connexion du véhicule. Le porte-balais comporte un composant de commande 12 à semi-conducteur du type Asic (circuit intégré) ou hybride, connu en soi, et mentionnés dans les documents US-A-5,675,205 et EP-A-0 731 550 précités. Le composant 12 est fixé à une embase métallique 14, éventuellement par l'intermédiaire d'une couche de colle bonne conductrice de la chaleur. Le porte-balais comporte des languettes ou traces métalliques 16 sur lesquelles le support 4 est surmoulé. Les languettes 16 sont connectées au composant 12 par des fils 18 classiques non illustrés. Elles sont par ailleurs connectées aux autres éléments électriques du circuit.

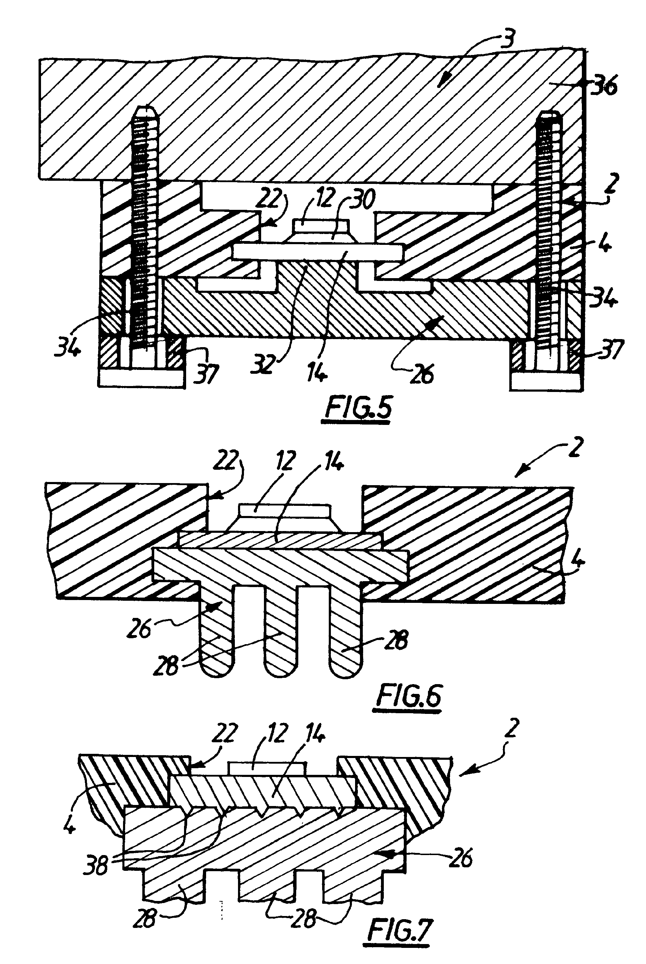

Comme illustré sur la figure 4, l'embase 14 a ici une forme profilée en « U.» à fond plat 20. L'embase résulte du pliage d'une feuille de métal. Une grande portion du fond 20 essentiellement parallèle au plan du support 4 s'étend dans une ouverture traversante 22 du support 4. Le composant 12 est fixé à l'embase 14 dans cette ouverture. L'embase présente deux flancs 24 parallèles entre eux, perpendiculaires au fond 20 et s'étendant d'un côté du fond opposé au composant 12. Le support 4 est surmoulé sur l'embase de sorte que les flancs 24 font saillie d'une face du support sur une plus grande partie de leur longueur et baignent dans l'air ambiant.

L'embase métallique appartient donc à un moyen de dissipation de chaleur métallique et est fixée au support électriquement isolant. L'embase 14 reçoit à fixation sur l'une de ses faces le composant 12 à la faveur de l'ouverture 22 fermée par l'embase. Cette embase à un coefficient de dilatation adapté à celui du composant et est réalisée par exemple en fer, fer-nickel ou cuivre.

Le moyen de dissipation de chaleur est en deux parties 14,26 distinctes et adjacentes, l'une des parties consistant en l'embase recevant sur son autre face un dissipateur de chaleur métallique formant la deuxième partie du moyen de dissipation de chaleur.

Dans cette figure le dissipateur 26 est adjacent à l'embase 14 en étant en contact direct avec celle-ci.

Ce porte-balais comporte un dissipateur principal profilé 26 à trois ailes planes 28 parallèles entre elles et muni d'une base 27. Ce dissipateur est rapporté sur le support 4, ici par clipsage, de sorte que sa base 27 vient en contact surfacique avec la face du fond 20 de l'embase du côté opposé au composant 12 et que les ailes 28 s'étendent parallèlement aux flancs 24 en regard de ceux-ci. Le dissipateur principal 26 est en aluminium. Les ailes 28 baignent ainsi dans l'air ambiant extérieur à la machine.

Ce dissipateur a ici, suivant une caractéristique, un coefficient de dilatation différent de celui de l'embase et avantageusement plus grand pour mieux évacuer la chaleur. Le composant 12 est logé dans l'épaisseur du support 4 à la faveur de l'ouverture 22.

Le dissipateur 26 s'étend en majeure partie à l'extérieur du support 4 du côté de l'embase opposé au composant 12, l'embase 14 étant intercalée entre le composant 12 et le dissipateur 26.

Le fond 27 du dissipateur est logé dans l'épaisseur du support. La taille maximale du fond 27 est déterminée par le diamètre interne de l'ouverture 22, ici de section circulaire.

Du fait que le dissipateur est rapporté, ici de manière amovible sur l'embase par clipsage, en variante non représentée par vissage, on peut standardiser le support et l'embase et monter de manière rapide le dissipateur de taille et de forme voulue sur l'embase. On évite ainsi de surmouler le dissipateur sur l'embase. Le diamètre externe du fond 27 peut être plus petit que celui de la figure 4 et sa hauteur peut être plus grande que celui de la figure 4. Tout dépend des applications. Il en est de même en ce qui concerne le choix de la matière et de la forme du dissipateur.

De préférence, comme visible à la figure 4, les ailes, formant ailettes 28 de refroidissement, s'étendent en saillie par rapport aux flancs 24 pour une meilleure évacuation de la chaleur.

Les ailes 28 sont donc plus hautes que les flancs.

Bien entendu on peut rapporter par collage le dissipateur sur le fond 20, la colle étant choisie pour être bonne conductrice de chaleur. Néanmoins cette disposition est moins favorable car on ne peut démonter ultérieurement le dissipateur pour le remplacer par un dissipateur plus adéquate en fonction des conditions d'utilisation du véhicule.

Dans tous les cas, on occupe au mieux l'espace disponible au niveau du support.

Grâce au surmoulage du support 4 sur l'embase l'ouverture 22 peut avoir une taille différente de part et d'autre de l'embase.

L'ouverture 22 est ici étagée, sa taille étant moindre au niveau du composant 12 qu'elle ne l'est au niveau du dissipateur 26 monté à jeu dans l'ouverture 22.

En fonctionnement, la chaleur dégagée par le composant 12 est transmise par contact au fond 20 de l'embase, puis aux flancs 24 de l'embase et au dissipateur principal. Ce dernier assure la plus grande partie de l'évacuation de la chaleur dégagée par le composant. Une petite partie de la chaleur est évacuée par les flancs 24. L'embase fait donc office de dissipateur secondaire. Les ailes 28 et les flancs 24 sont refroidis par l'air ambiant extérieur à la machine.

La figure 5 illustre un deuxième mode de réalisation. Dans celui-ci, le support 4 est encore surmoulé sur l'embase 14 qui a ici une forme plane. L'embase porte le composant 12 par l'intermédiaire d'une couche de colle thermiquement conductrice 30. Le dissipateur 26 a ici une forme essentiellement plane. Il est fixé au support 4, parallèlement à celui-ci. Le dissipateur 26 comporte une proéminence 32 s'étendant à jeu dans l'ouverture 22 et ayant une face plane d'extrémité venant en contact surfacique avec la face de l'embase 14 opposée au composant 12, lequel est dirigé vers la machine. La machine comporte des vis de fixation 34 traversant chacune un orifice du dissipateur 26, un orifice du support 4 et un orifice d'un palier 36 du carter de la machine. Ainsi, les mêmes vis 34 assurent la fixation du dissipateur 26 au support 4 et la fixation du support 4 à la machine.

Le dissipateur est moins haut que celui de la figure 4 mais est plus large ce qui permet de bien dissiper la chaleur. L'embase 14 est montée dans l'épaisseur du support, la proéminence 32 ayant un diamètre extérieur inférieur au diamètre interne de l'ouverture 22.

La chaleur dégagée par le composant 12 est transmise à la colle conductrice 30 puis à l'embase 14 et au dissipateur 26, lequel baigne dans l'air ambiant par sa face opposée au support. Le dissipateur pourrait ici encore avoir des ailes.

Le porte-balais comporte des rondelles thermiquement isolantes 37, par exemple en élastomère, interposées entre la tête des vis 34 et le dissipateur 26, de sorte que la chaleur du palier 36 transmise aux vis ne se transmet pas au dissipateur. On pourra aisément concevoir le dissipateur de façon à réduire au minimum ses contacts avec les tiges des vis.

Comme à la figure 4 le dissipateur est montable et démontable à volonté.

Dans le mode de réalisation de la figure 6, qui est librement compatible avec les deux précédents, le support 4 est surmoulé sur l'embase 14 et sur le dissipateur 26 qui sont ainsi par ce moyen fixés en contact l'un à l'autre.

Dans ce cas le fond du dissipateur est plus large que l'embase 14.

Dans le mode de réalisation de la figure 7, lui aussi librement compatible avec les trois précédents, l'embase 14 présente sur sa face opposée au composant 12 des reliefs aiguisés 38 s'étendant en saillie. Ces reliefs pénètrent dans la face en regard du dissipateur 26 lorsque l'embase est accolée au dissipateur plus large. Ces reliefs 38 constituent des ponts thermiques pour l'évacuation de la chaleur vers le dissipateur 26. Certains au moins des reliefs pourraient être portés par le dissipateur.

Dans chacun de ces modes de réalisation, on pourra interposer une couche thermiquement conductrice entre l'embase et le dissipateur.

En variante l'invention peut être appliquée à un démarreur de véhicule automobile dont l'induit est constitué par le rotor bobiné et l'inducteur par le stator. Dans tous les cas l'embase est logée par son fond dans l'épaisseur du support 4.

Le dissipateur peut n'être qu'en matière plastique chargé par des éléments métalliques pour bien évacuer la chaleur.

En variante l'embase peut être fixée par collage sur le support.

## Revendications

1. Porte-balais (2) de machine électrique de véhicule, ledit porte-balais étant adapté à être monté sur un carter (36) de ladite machine électrique, comportant
- un support isolant (4) ;
- une embase métallique fixée au support (4) et un circuit électrique comprenant un composant de commande (12) à semi-conducteur, dans lequel l'embase (14) d'une part, reçoit à fixation sur l'une de ses faces le composant de commande (12) à la faveur d'une ouverture (22) du support (4) et d'autre part appartient à un moyen de dissipation de chaleur (14, 26) agencé pour recevoir de la chaleur du composant de commande (12), **caractérisé en ce que** le composant de commande (12) est destiné à être disposé du côté de la machine électrique et **en ce que** l'embase reçoit sur l'autre de ses faces un dissipateur de chaleur en sorte que le moyen de dissipation (14,26) de chaleur est composé de deux parties distinctes et adjacentes, le moyen de dissipation de chaleur (14, 26) étant apte à être en contact avec le milieu ambiant extérieur à la machine.

2. Porte-balais selon la revendication 1, **caractérisé en ce que** l'embase (14) et le support (4) ont un coefficient de dilatation différent.

3. Porte-balais selon la revendication 1 ou 2, **caractérisé en ce que** le dissipateur (26) a un coefficient de dilatation supérieur à celui de l'embase.

4. Porte-balais selon l'une quelconque des revendications 1 à 3, **caractérisé en ce que** le support (4) est surmoulé sur l'embase (14).

5. Porte-balais selon l'une quelconque des revendications 1 à 4, **caractérisé en ce que** le support (4) est surmoulé sur le dissipateur (14, 26).

6. Porte-balais selon l'une quelconque des revendications1 à 4, **caractérisé en ce que** le dissipateur (26) est rapporté sur le support (4).

7. Porte-balais selon la revendication 6, **caractérisé en ce que** le dissipateur (26) est fixé par vis (34) sur le support (4).

8. Porte-balais selon l'une quelconque des revendications 1 à 7, **caractérisé en ce qu'**il comprend une couche thermiquement conductrice (30) interposée entre l'embase (14) et le dissipateur (26).

9. Porte-balais selon l'une quelconque des revendications 1 à 7, **caractérisé en ce que** l'embase (14) et le dissipateur (26) sont en contact direct.

10. Porte-balais selon la revendication 9, **caractérisé en ce que** l'un (14) au moins parmi l'embase (14) et le dissipateur (26) présente des reliefs saillants (38) aptes à pénétrer dans le matériau de l'autre (26) parmi l'embase et le dissipateur lorsqu'ils sont placés en position de fonctionnement du porte-balais.

11. Porte-balais selon l'une quelconque des revendications 1 à 10, **caractérisé en ce que** le dissipateur (26) est en métal, tel que de l'aluminium.

12. Porte balais selon l'une des revendications précédentes, **caractérisé en ce que** le dissipateur additionnel de chaleur (26) ayant une base (27) qui vient en contact surfacique avec un fond (20) de l'embase (14).

13. Porte balais selon l'une des revendications précédentes, **caractérisé en ce que** le dissipateur de chaleur (26) comporte des ailes (28).

14. Machine électrique (3) de véhicule, **caractérisée en ce qu'**elle comprend un porte-balais (2) selon l'une quelconque des revendications 1 à 13.

15. Machine électrique (3) de véhicule, **caractérisée en ce qu'**elle comprend un porte-balais selon la revendication 7, la ou au moins l'une des vis (34) de montage du dissipateur (26) sur le support (4) assurant la fixation du porte-balais (2) sur un carter de la machine.

16. Machine selon là revendication 15, **caractérisée en ce qu'**un élément thermiquement isolant (37) est interposé entre la ou chaque vis (34) et le dissipateur (26).

17. Machine selon l'une quelconque des revendications 14 à 16, **caractérisée en ce qu'** il s'agit d'un alternateur, d'un alterno-démarreur ou d'un démarreur.

## Claims

1. Brush-holder (2) for an electric machine of a vehicle, the said brush-holder being designed to be fitted on a housing (36) of the said electric machine, comprising:
- an insulating support (4);
- a metal base secured to the support (4); and
an electric circuit comprising a semi-conductor control component (12), wherein the base (14) firstly receives secured onto one of its surfaces the control component (12) to assist an opening (22) in the support (4), and secondly belongs to a means (14, 26) for dissipation of heat which is designed to receive the heat from the control component (12), **characterised in that** the control component (12) is designed to be disposed on the side of the electric machine, and **in that** the base receives on the other one of its surfaces a heat dissipater, such that the means (14, 26) for dissipation of heat consists of two distinct and adjacent parts, the means (14, 26) for dissipation of heat being able to be in contact with the ambient environment outside the machine.

2. Brush-holder according to claim 1, **characterised in that** the base (14) and the support (4) have a different coefficient of expansion.

3. Brush-holder according to claim 1 or claim 2, **characterised in that** the dissipater (26) has a coefficient of expansion greater than that of the base.

4. Brush-holder according to any one of claims 1 to 3, **characterised in that** the support (4) is over-moulded on the base (14).

5. Brush-holder according to any one of claims 1 to 4, **characterised in that** the support (4) is over-moulded on the dissipater (14, 26).

6. Brush-holder according to any one of claims 1 to 4, **characterised in that** the dissipater (26) is added onto the support (4).

7. Brush-holder according to claim 6, **characterised in that** the dissipater (26) is secured by screws (34) onto the support (4).

8. Brush-holder according to any one of claims 1 to 7, **characterised in that** it comprises a thermally conductive layer (30) interposed between the base (14) and the dissipater (26).

9. Brush-holder according to any one of claims 1 to 7, **characterised in that** the base (14) and the dissipater (26) are in direct contact.

10. Brush-holder according to claim 9, **characterised in that** at least one (14) from amongst the base (14) and the dissipater (26) has projecting reliefs (38) which can penetrate in the material of the other (26) from amongst the base and the dissipater when they are placed in the position of functioning of the brush-holder.

11. Brush-holder according to any one of claims 1 to 10, **characterised in that** the dissipater (26) is made of metal, such as aluminium.

12. Brush-holder according to one of the preceding claims, **characterised in that** the additional heat dissipater (26) has a base (27) which comes into surface contact with a bottom (20) of the base (14).

13. Brush-holder according to one of the preceding claims, **characterised in that** the heat dissipater (26) comprises wings (28).

14. Electric machine (3) of a vehicle, **characterised in that** it comprises a brush-holder (2) according to one of claims 1 to 13.

15. Electric machine (3) of a vehicle, **characterised in that** it comprises a brush-holder according to claim 7, the or at least one of the screws (34) for fitting of the dissipater (26) onto the support (4) assuring the securing of the brush-holder (2) onto a housing of the machine.

16. Machine according to claim 15, **characterised in that** a thermally insulating element (37) is interposed between the or each screw (34) and the dissipater (26).

17. Machine according to any one of claims 14 to 16, **characterised in that** it consists of an alternator, an alternator-starter, or a starter.

## Patentansprüche

1. Bürstenhalter (2) einer elektrischen Maschine für Kraftfahrzeuge, wobei der besagte Bürstenhalter für die Anbringung an einem Gehäuse (36) der besagten elektrischen Maschine geeignet ist, umfassend:
- einen nichtleitenden Träger (4);
- einen am Träger (4) befestigten Metallsockel
und einen elektrischen Stromkreis, der wenigstens ein Halbleiter-Steuerbauteil (12) enthält, wobei der Sockel (14) einerseits das auf einer seiner Flächen befestigte Steuerbauteil (12) mittels einer Öffnung (22) des Trägers (4) aufnimmt und andererseits zu einem Wärmeableitmittel (14, 26) gehört, das angeordnet ist, um Wärme vom Steuerbauteil (12) aufzunehmen, **dadurch gekennzeichnet, dass** das Steuerbauteil (12) dazu bestimmt ist, auf der Seite der elektrischen Maschine angeordnet zu werden, und dass der Sockel auf der anderen seiner Flächen einen Kühlkörper aufnimmt, so dass das Wärmeableitmittel (14, 26) aus zwei unterschiedlichen und benachbarten Teilen besteht, wobei sich das Wärmeableitmittel (14, 26) mit der äußeren Umgebung der Maschine in Kontakt befinden kann.

2. Bürstenhalter nach Anspruch 1, **dadurch gekennzeichnet, dass** der Sockel (14) und der Träger (4) einen unterschiedlichen Ausdehnungskoeffizienten haben.

3. Bürstenhalter nach Anspruch 1 oder 2, **dadurch gekennzeichnet, dass** der Kühlkörper (26) einen größeren Ausdehnungskoeffizienten als der Sockel hat.

4. Bürstenhalter nach einem der Ansprüche 1 bis 3, **dadurch gekennzeichnet, dass** der Träger (4) auf dem Sockel (14) aufgeformt ist.

5. Bürstenhalter nach einem der Ansprüche 1 bis 4, **dadurch gekennzeichnet , dass** der Träger (4) auf dem Kühlkörper (14, 26) aufgeformt ist.

6. Bürstenhalter nach einem der Ansprüche 1 bis 4, **dadurch gekennzeichnet, dass** der Kühlkörper (26) auf dem Träger (4) angefügt ist.

7. Bürstenhalter nach Anspruch 6, **dadurch gekennzeichnet, dass** der Kühlkörper (26) durch Schrauben (34) auf dem Träger (4) befestigt ist.

8. Bürstenhalter nach einem der Ansprüche 1 bis 7, **dadurch gekennzeichnet, dass** er eine wärmeleitende Schicht (30) umfasst, die zwischen dem Sockel (14) und dem Kühlkörper (26) eingefügt ist.

9. Bürstenhalter nach einem der Ansprüche 1 bis 7, **dadurch gekennzeichnet , dass** sich der Sockel (14) und der Kühlkörper (26) in direktem Kontakt befinden.

10. Bürstenhalter nach Anspruch 9, **dadurch gekennzeichnet, dass** wenigstens eines (14) der Teile Sockel (14) und Kühlkörper (26) vorstehende Erhebungen (38) aufweist, die in das Material des anderen (26) der Teile Sockel und Kühlkörper eindringen können, wenn sie in die Betriebsposition des Bürstenhalters gebracht werden.

11. Bürstenhalter nach einem der Ansprüche 1 bis 10, **dadurch gekennzeichnet, dass** der Kühlkörper (26) aus einem Metall, etwa aus Aluminium, besteht.

12. Bürstenhalter nach einem der vorangehenden Ansprüche, **dadurch gekennzeichnet , dass** der zusätzliche Kühlkörper (26) eine Basis (27) aufweist, die in Oberflächenkontakt mit einem Boden (20) des Sockels (14) kommt.

13. Bürstenhalter nach einem der vorangehenden Ansprüche, **dadurch gekennzeichnet , dass** der Kühlkörper (26) Rippen (28) umfasst.

14. Elektrische Maschine (3) für Fahrzeuge, **dadurch gekennzeichnet, dass** sie einen Bürstenhalter (2) nach einem der Ansprüche 1 bis 13 umfasst.

15. Elektrische Maschine (3) für Fahrzeuge, **dadurch gekennzeichnet, dass** sie einen Bürstenhalter nach Anspruch 7 umfasst, wobei die bzw. wenigstens eine der Schrauben (34) zur Anbringung des Kühlkörpers (26) auf dem Träger (4) die Befestigung des Bürstenhalters (2) auf einem Gehäuse der Maschine übernehmen.

16. Maschine nach Anspruch 15, **dadurch gekennzeichnet, dass** ein nicht wärmeleitendes Element (37) zwischen der bzw. jeder Schraube (34) und dem Kühlkörper (26) eingefügt ist.

17. Maschine nach einem der Ansprüche 14 bis 16, **dadurch gekennzeichnet , dass** es sich um einen Wechselstromgenerator, einen Anlassergenerator oder einen Anlasser handelt.
